## Europäisches Patentamt

(19) **European Patent Office**

**Office européen des brevets**

(11) Veröffentlichungsnummer : **0 055 376**
**B1**

(12) # EUROPÄISCHE PATENTSCHRIFT

(45) Veröffentlichungstag der Patentschrift :
09.10.85

(51) Int. Cl.⁴ : **G 02 B   6/14**

(21) Anmeldenummer : **81109161.0**

(22) Anmeldetag : **29.10.81**

(54) **Anschlussteil für das lösbare Verbinden eines Halbleiterchips mit ihm.**

(30) Priorität : **30.12.80 US 221678**

(43) Veröffentlichungstag der Anmeldung :
**07.07.82 Patentblatt 82/27**

(45) Bekanntmachung des Hinweises auf die Patenterteilung : **09.10.85 Patentblatt 85/41**

(84) Benannte Vertragsstaaten :
**DE FR GB**

(56) Entgegenhaltungen :
**DE-A- 2 321 834**
**US-A- 3 879 606**
**US-A- 4 169 001**
**US-A- 4 225 213**

(73) Patentinhaber : **International Business Machines Corporation**
**Old Orchard Road**
**Armonk, N.Y. 10504 (US)**

(72) Erfinder : **Adham, Jawad Faik**
**R.D. Nr. 2 Box 253B**
**Vestal New York 13850 (US)**

(74) Vertreter : **Neuland, Johannes, Dipl.-Ing.**
**Schönaicher Strasse 220**
**D-7030 Böblingen (DE)**

EP 0 055 376 B1

## Beschreibung

Die Erfindung bezieht sich auf ein Anschlußteil für das lösbare Verbinden eines Halbleiterchips mit ihm.

Geeignete Anordnungen zum Verbinden von monolithisch hochintegrierte Schaltungen enthaltenden Halbleiterchips mit anderen Schaltungen oder Geräten sind bekannt. Seit deren erstem kommerziellen Erscheinen hat die ständig zunehmende Schaltkreisdichte solcher Halbleiterchips einen fortwährenden Druck auf diejenigen ausgeübt, die das Problem der Verbindungsherstellung zu geeigneten Punkten all der beteiligten Schaltungen bei geringer werdendem dafür zur Verfügung stehenden Platz zu lösen hatten. Mit zunehmender Schaltkreisdichte und Verlustleistungswärme bei einem modernen Halbleiterchip wurden neue Packungsverfahren ausprobiert, um die Probleme zu lösen, die die Herausforderung aufwarf, ein sehr kompliziertes elektronisches System in einer möglichst kleinen Packungsanordnung unterzubringen.

Darüber hinaus verursachte der Trend nach Mehrfunktions-Halbleiterchips bei der Herstellung monolithisch integrierter Schaltungen selbst ein dramatisches Anwachsen der Anzahl der sich ergebenden Verbindungen in dem Verdrahtungsnetzwerk, auf der Schaltkarte mit gedruckten Leiterzügen oder der Packungsanordnung, in der die neuen Halbleiterchips benutzt wurden. Außerdem schuf der Wunsch, die Geschwindigkeit der Informationsverarbeitung und -übertragung zu steigern, Probleme bezüglich der Verbindung der Halbleiterchips in der Weise, daß die Anzahl der zulässigen Eingangs-/Ausgangsverbindungen, die erforderlich waren, um solche höheren Geschwindigkeiten zu erzielen, begrenzt wurde durch die Störspannungen, die sie im Betrieb verursachen. Offensichtlich verursacht das Schalten einer großen Anzahl von Eingangs-/Ausgangsverbindungen zu einem Zeitpunkt genügend hohe Signalpegel und Störspannungen, um dadurch das einwandfreie Arbeiten der Schaltungen des Halbleiterchips nachteilig zu beeinflussen. Während dieses Problem teilweise gelöst wurde durch zeitliches Aufeinanderfolgen der Eingabe-/Ausgabeoperationen des Halbleiterchips oder durch Anwendung equivalenter Verfahren, erforderten solche Lösungen zusätzliche Schaltungen und hatten eine langsamere Betriebsweise zur Folge, was weit dahinter zurückblieb, die durch die dichtere Schaltungsanordnung auf dem Halbleiterchip gegebenen Möglichkeiten vorteilhaft und voll auszunutzen.

Daher ist der Trend nach weiterer Miniaturisierung, ständig wachsenden Schaltkreisdichten, höheren Übertragungsgeschwindigkeiten und größeren Verarbeitungsgeschwindigkeiten die Ursache für Verringerungen in dem für Verbindungen zwischen den Halbleiterchips zu Verfügung stehenden Platz. Dies wiederum ist die Ursache für eine erhöhte Empfindlichkeit gegenüber Signalstörungen, insbesondere gegenüber beim Ein-/Ausschalten entstehenden Störspannungen, da verschiedene Versuche unternommen wurden, sich dem kleineren Platz für Verbindungen zwischen den Halbleiterchips anzupassen. Auch machten die Forderungen für solche Zwischenverbindungen es schwierig, wenn nicht unmöglich, eine Reparatur beim Benutzer durchzuführen oder einfach veraltete Halbleiterchips zu ersetzen. Als Folge davon entstand ein großer Bedarf nach anpassungsfähigen Packungskonzepten für Halbleiterchips, die sich den neuesten Halbleiterchips bei deren Verfügbarkeit anpassen, ohne die Anzahl der Eingangs-/Ausgangsverbindungen ungebührlich zu begrenzen, die damit hergestellt werden können und ohne den verhältnismäßig schnellen und leichten Austausch der Halbleiterchips beim Kunden zu stören.

Aus dem US-Patent 3 879 606 ist ein Packungskonzept bekannt, bei dem Halbleiterchips miteinander durch einen lichtleitenden Weg und lichtempfindliche Elemente in den Halbleiterchips selbst gekoppelt sind. Notwendigerweise dient eine Lichtquelle dazu, einen gegebenen Lichtpfad zu beleuchten, worauf die lichtempfindlichen Halbleiterelemente in diesem Lichtpfad ansprechen und dadurch die gewünschten Schaltungen miteinander koppeln. Dadurch sollten Kurzschlüsse und/oder durch Streukapazitäten bedingte Probleme in der Anordnung zum Packen der Halbleiterchips vermieden werden. Im US-Patent 3 969 816 ist ein Verbindungssystem für gebondete Drähte beschrieben, das optische Leiter benutzt. Den US-Patenten 3 904 262, 4 063 791, 4 164 003 und 4 166 665 ist das fortdauernde Bemühen zu entnehmen, einen leicht ausbaubaren Anschluß für Anordnungen zum Packen von Halbleiterchips zu schaffen, der die augenblicklichen und zukünftigen Forderungen für das Packen, einschließlich derjenigen der Kühlung der Halbleiterchips und ihrer gegenseitigen Verbindung erfüllt.

Leider waren diese und andere ähnliche Versuche nach dem Stand der Technik nicht voll wirksam beim Lösen der vorher erwähnten Packungsprobleme. Es bleibt noch das Problem der beim Schalten entstehenden Störspannung, das sich durch die bloße Anzahl der herzustellenden Verbindungen ergibt und das Problem der Wärmeabfuhr, das aus dem Energiebedarf und der Verwendung der modernen Mehrfunktions-Halbleiterchips entsteht. Außerdem war eine größere Lebenserwartung für einen Entwurf zum Packen der Halbleiterchips nicht erzielbar, wenn jede neue Generation von Halbleiterchips eine Menge von Packungskonzepten hervorbrachte, die nur die unmittelbaren Probleme einer bestimmten Chipkonfiguration ansprachen. Ferner wurde offensichtlich, daß es höchst nützlich wäre, Anschlüsse für die Halbleiterchips vorzusehen, die in der Lage waren, die Halbleiterchips direkt in einem einstufigen Packungsverfahren aufzubringen anstatt sie auf Modulen zu befestigen und über diese die externen Verbindungen herzustellen.

Hier will die Erfindung Abhilfe schaffen. Die Erfindung, wie sie in den Ansprüchen gekennzeichnet ist, löst die Aufgabe, ein Anschlußteil für das lösbare Verbinden eines Halbleiterchips mit ihm anzugeben, das das Problem der Herstellung einer großen Anzahl von Verbindungen mit dem Halbleiterchip ohne Rücksicht auf oder Begrenzung durch die Probleme der beim Schalten entstehenden Störspannungen löst, die beim Betrieb der hochintegrierten Halbleiterschaltungen erzeugte Wärme wirksam ableitet und ein rasches und leichtes Austauschen des Halbleiterchips ermöglicht.

Im folgenden wird die Erfindung anhand von lediglich einen Ausführungsweg darstellenden Zeichnungen näher erläutert. Es zeigt :

Figur 1 eine Schnittansicht des oberen Teils eines mehrschichtigen Anschlußteiles vor dem Erzeugen eines Platzes für das Aufnehmen des Halbleiterchips ;

Figur 2 eine Schnittansicht des oberen Teiles des Anschlußteils nach Fig. 1, der mit einem Platz für das Aufnehmen des Halbleiterchips versehen ist ;

Figur 3 eine andere Schnittansicht des oberen Teils des Anschlußteils nach Fig. 1, bei dem der Platz für das Halbleiterchip in einem fortgeschritteren Zustand der Vollendung dargestellt ist neben einem Unterteil des Anschlußteils, der in einem vorbereitenden Zustand der Vollendung dargestellt ist ;

Figur 4 eine Schnittansicht des oberen Teiles des Anschlußteils nach Fig. 3, die einen vervollständigten Platz für das Halbleiterchip zeigt und ein solches trägt und eine Schnittansicht des unteren Teiles des Anschlusses nach Fig. 3 in einem vollendeten Zustand, wobei beide Teile betriebsfähig miteinander verbunden sind und

Figur 5 eine schematische Ansicht eines Halbleiterchips, das sich an seinem Platz befindet sowie seine Arretiervorrichtung.

Mit dem Ausdruck Halbleiterchip mit monolithisch hochintegrierten Schaltungen wird ein Halbleiterchip bezeichnet, das eine enorme Anzahl von Schaltungen enthält, im allgemeinen in der Größenordnung von 4 bis 8 000 Schaltungen. Gegenwärtig verfügbare Halbleiterchips mit hoher Dichte der Bauelemente haben eine obere Grenze von 35 bis 50 Eingabe-/Ausgabeverbindungen, die gleichzeitig geschaltet werden können, abhängig von der Anzahl und der Art der verwendeten Treiberschaltungen.

Andererseits würde die Verwendung von Glasfaseroptik anstelle der üblichen Verbindungsmittel eine Verbesserung der Anzahl der zulässigen Eingangs-/Ausgangsverbindungen des Halbleiterchips, die gleichzeitig geschaltet werden können, ohne die Betriebsweise des Halbleiterchips nachteilig zu beeinflusses, um mindestens zwei Größenordnungen erlauben. Außerdem würde die Verwendung von Glasfaserkabeln das Problem der Signaldämpfung bedeutend verringern, wenn die beiden Verbindungspunkte voneinander entfernt sind und gleichzeitig eine Verbesserung der Signalübertragungszeiten ermöglichen. Der hier verwendete Ausdruck « Glasfaserkabel » bezieht sich auf ein übliches Glasfaserbündel eines oder mehrerer Stränge, die so gebildet werden, wie das beispielsweise in der September-Ausgabe 1978 der Zeitschrift « Electronic Products » auf den Seiten 39 bis 51 beschrieben ist.

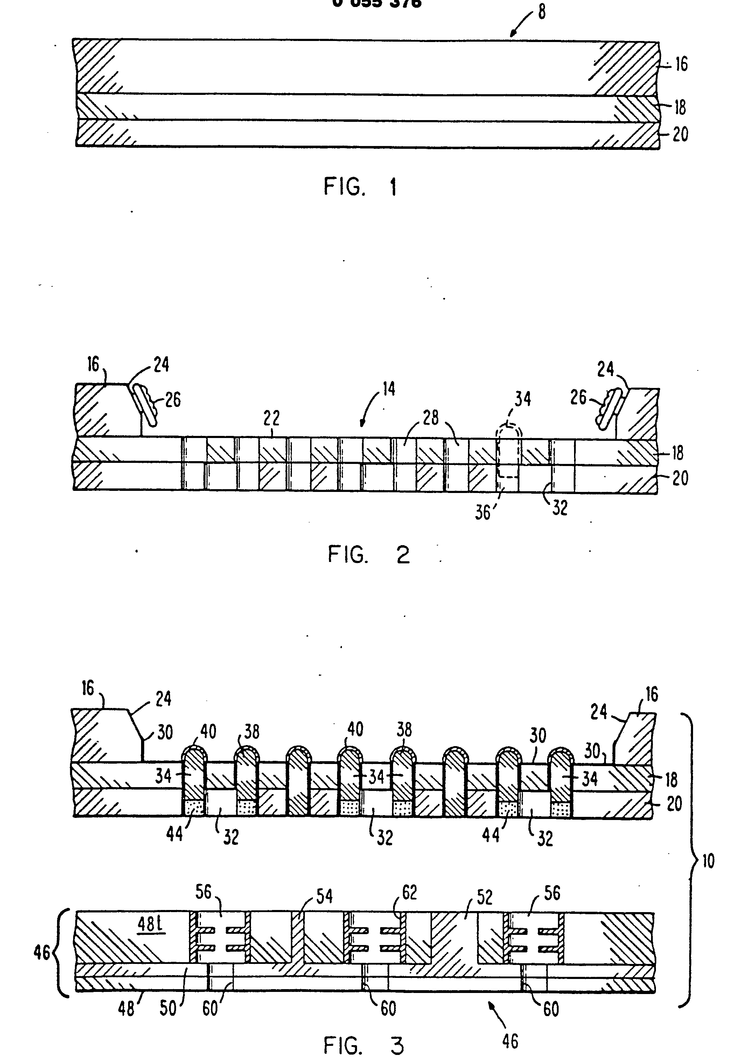

Fig. 1 zeigt schematisch im Querschnitt den mehrschichtigen oberen Teil 8 eines Anschlußteils 10, der dazu dienen soll, ein Halbleiterchip 12 mit monolithisch integrierten Schaltungen in einer Weise und unter Verwendung von zusammenarbeitenden Elementen auf einem Platz 14 für das Halbleiterchip unterzubringen, wie das noch beschrieben wird. Vorzugsweise wird ein mehrschichtiger Anschlußteil 10 als Aufnahme für das Halbleiterchip 12 benutzt, obwohl es einzusehen ist, daß das Anschlußteil 10 auch aus einem massiven Teil anstatt aus einem zusammengesetzten gebildet werden kann. Mehrschichtige Anschlußteile werden jedoch vorzugsweise verwendet, um die Wirkungen von Wirbelströmen und Hystereseeffekten zu verringern oder zu eliminieren. Auch lassen sich mehrschichtige Anschlußteile leichter und kostengünstiger herstellen. Obgleich nur die Teile eines Anschlußteiles 10 und ein Platz 14 zur Aufnahme eines Halbleiterchips in den verschiedenen Zeichnungen aus Gründen der Einfachheit dargestellt sind, ist es einzusehen, daß eine Reihe von Plätzen vorgesehen werden könnte durch ähnliche Verbindungsteile und an jedem Platz ein Halbleiterchip befestigt werden könnte, wie das für ein einzelnes Halbleiterchip und seinen Platz beschrieben wird.

Der obere Teil 8 des Anschlußteiles 10 enthält in diesem Beispiel drei leitende Schichten 16, 18 und 20, die in üblicher Weise miteinander verbunden oder laminiert sind. Zur Bildung des Platzes 14 für das Halbleiterchip werden die obersten Schichten gebohrt oder es wird in anderer Weise in ihnen eine Öffnung erzeugt, wie das in Fig. 2 dargestellt ist. Dadurch wird die gesamte obere Schicht 16 an dem Platz 14 für das Halbleiterchip entfernt und legt einen Teil 22 der Oberfläche der mittleren Schicht 18 frei. Es sei bemerkt, daß die Form der Öffnung für den Platz 14 des Halbleiterchips leicht der Form des darin einzusetzenden Halbleiterchips angepaßt werden kann, wodurch jederzeit eine rasche und richtige Orientierung des Halbleiterchips sichergestellt wird. Ungeachtet seiner besonderen äußeren Form dient der obere Teil 8 des Anschlußteiles 10 als leitender Rand, der zwei bestimmte Zwecke hat. Der obere Teil 8 dient als Wärmesenke, um die beim Betrieb des Halbleiterchips 12 erzeugte Wärme von dem Platz 14 abzuführen und dient auch als Abschirmung für externe Signale, die sonst den einwandfreien Betrieb des Halbleiterchips stören könnten.

Die oberste Schicht 16 wird dann mit einer abgeschrägten Kante 24 versehen, wie das in Fig.

2 dargestellt ist, auf die eine Klemme 26 aufgeklebt oder befestigt wird für einen noch zu beschreibenden Zweck. Die Klemme 26 ist vorzugsweise aus einem oder mehreren Streifen eines Isoliermaterials geeigneter Dicke gebildet, wie z. B. aus einem Polyester oder Polyimid, das die noch anzugebenden Eigenschaften besitzt. Die Klemme 26 kann daher aus irgendeinem geeigneten Material gebildet werden, das die erforderlichen Eigenschaften besitzt, wie z. B. der Polyester Mylar oder das Polyimid Keptan. Das Material wird befestigt entweder durch einen Klebstoff aus Akrylpolymer oder durch übliche mechanische Mittel wie einen Stift oder eine Heftklammer.

Eine Reihe von Löchern 28 werden in den Boden des Platzes 14 für das Halbleiterchip gebohrt, die sich vollständig durch die leitenden Schichten 18 und 20 erstrecken. Die freiliegende Oberfläche 22 der mittleren Schicht 18 und die Wandungen der Löcher 28 werden dann mit einer isolierenden Schicht 30 eines geeigneten Materials, wie z. B. Polyimid, beschichtet. Die isolierende Schicht 30 wird über die gesamte freiliegende Oberfläche der leitenden mittleren Schicht 18 und teilweise auf die Kante 24 der obersten Schicht 16 aufgebracht, wie das am klarsten in Fig. 3 dargestellt ist. Eine Reihe von Löchern 32 werden jetzt nur in der unteren Schicht 20 angebracht, zwischen nur einigen vorbestimmten Löchern 28, für einen noch zu beschreibenden Zweck. Die Löcher 32 erstrecken sich dort, wo sie gebildet wurden, zwischen den Löchern 28 und entfernen die isolierende Schicht 30 von den unteren Teilen bis zu der Höhe der Lage 20. Die Löcher 28 werden mit elektrisch leitenden Verbindungsstiften 34 versehen, die fest darin eingeklemmt werden und sich entweder vollständig nach unten zur unteren Fläche der Lage 20 erstrecken oder teilweise einen Hohlraum 36 in der Nähe des Grundes der Löcher 28, die sie besetzen, freilassen. Die Köpfe 38 der Verbindungsstifte 34 sind gewölbt und erstrecken sich in den oberen Teil des Platzes 14 für das Halbleiterchip oberhalb der mittleren Schicht 18. Die Verbindungsstifte 34 sind einschließlich ihrer Köpfe 38 aus einem leitenden Material hergestellt, wie z. B. Kupfer, und möglicherweise einem oder mehreren damit legierten zusätzlichen Materialien, um die gewünschten Stifteigenschaften zu erhalten. Eine zufriedenstellende Mischung aus 99,75 % Kupfer und 0,20 % Zirkonium, bei der die restlichen 0,05 % metallische Verunreinigungen waren, ist für die Stifte der beschriebenen Art benutzt worden. Alternativ können die Köpfe 38 der Verbindungsstifte aus einem leicht deformierbaren Material hergestellt werden, wie z. B. einer Legierung von Blei mit Zinn oder Indium, wie sie für die Anschlußflächen am Halbleiterchip benutzt wird. Die Anschlußflächen 38 sind mit einer Schicht 40, z. B. aus Gold, versehen, um eine Oxidbildung zu verhindern und die nachfolgende Störung der Verbindung.

Eine Reihe optischer Wandler 42, bei denen es sich in dem bevorzugten Ausführungsbeispiel um Sender-Empfänger für optische Systeme handelt, sind in den Löchern 32 eingesetzt. Der Sender-Empfänger für optische Systeme 42 ist ein Element mit doppeltem Zweck, das ein Lichtsignal erzeugt als Antwort auf ein eintreffendes elektrisches Signal, wenn es im Sendebetrieb arbeitet und das das umgekehrte tut, wenn es im Empfangsbetrieb arbeitet. Weitere Einzelheiten über Sender-Empfänger für optische Systeme sind beispielsweise in der Ausgabe der Zeitschrift « Electronic Design News » vom 5. Februar 1979 auf den Seiten 72 bis 76 beschrieben. Es hätten auch Wandler verwendet werden können, die nur einem Zweck dienen, d. h. es hätten getrennte Sender und Empfänger verwendet werden können, aber das würde offensichtlich die Anzahl und die Kosten der benutzten Elemente erhöht haben als auch die Kosten für das Bereitstellen des Platzes 14 für das Halbleiterchip, um diese erhöhte Anzahl an Elementen unterzubringen.

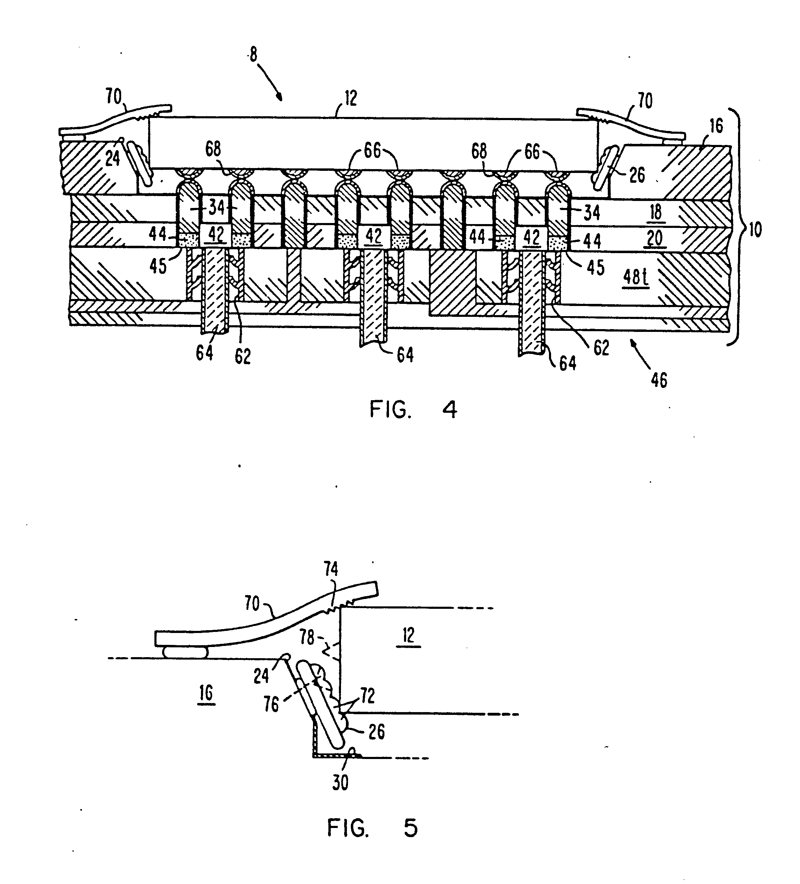

Der obere Teil 8 des Anschlußteiles 10 wird dann mit einem unteren Teil 46 verbunden, das ein unabhängiges Element sein kann. Das Unterteil 46 kann alternativ und vorzugsweise aus einer üblichen 46 kann alternativ und vorzugsweise aus einer üblichen Schaltkarte mit gedruckten Leiterzügen gebildet sein. Wenn das Unterteil 46 als Schaltkarte ausgeführt ist, ist es aus mehreren isolierenden Schichten 48 und aus leitenden Schichten 50 hergestellt, wie das in den Fign. 3 und 4 dargestellt ist. Die isolierenden Schichten 48 sind aus einem harzimprägnierten Glasfasergewebe hergestellt, das in bekannter Weise genügend ausgehärtet wurde. Die leitenden Schichten 50 hergestellt, wie das in den Fig. 3 ge für die Leitungen 52 und 54 gebildet werden, wurden aus einer Kupferfolie geformt. Wenn, wie das für das bevorzugte Ausführungsbeispiel der Erfindung beabsichtigt, das Unterteil 46 eine Schaltkarte mit gedruckten Leiterzügen ist, wird sie in üblicher Weise mit einer geeigneten Anzahl von Signal- oder Spannungsversorgungsebenen hergestellt, die durch isolierende Schichten getrennt sind. Die Einzelheiten eines Beispiels für die Herstellung einer solchen Schaltkarte sind im US-Patent 4 030 190 beschrieben.

Eine Reihe von Löchern 56 werden gebohrt oder gebildet in der obersten isolierenden Schicht 48t und vollständig durch sie hindurch. Die Löcher 56 werden so gebildet, daß sie koaxial ausgerichtet sind mit den Löchern 32 und den Sendern-Empfängern der optischen Systeme 42, wenn das Unterteil 46 mit dem Rest des Anschlußteiles 10 verbunden wird. Ein Loch 56 wird für jedes der Löcher 32 gebohrt, das ein optisches System 42 mit Sender und Empfänger enthält. Eine andere Reihe von Löchern 60 werden in dem Unterteil 46 gebohrt und erstrecken sich darin in koaxialer Ausrichtung mit den Löchern 56. Bauteile 62 zur Befestigung der Glasfaserkabel sind in den Löchern 56 befestigt und ein Glasfaserkabel 64 ist seinerseits in jedem der Bauteile 62 befestigt. Die Glasfaserkabel 64 sind in Kontakt mit den optischen Wandlern 42 angeordnet und erstrecken sich von dort in das Unterteil 46 durch die Löcher 60 zu nicht dargestellten Schaltungen, mit denen eine Verbindung des Halbleiterchips gewünscht wird.

Das Halbleiterchip 12 selbst weist nicht die üblichen Eingangs-/Ausgangsstiftverbindungen auf und ist stattdessen mit einer geeigneten Anzahl von Anschlußflächen 66 versehen, die aus einer verformbaren Bleilegierung bestehen und eine darauf befindliche leitende Schutzschicht 68, ähnlich der Schicht 40 aufweisen. Beim Einsetzen des Halbleiterchips 12 auf den Platz 14 werden die Anschlußflächen 66 unter der Wirkung der Klemmen 26 auf die Anschlußflächen 38 des Halbleiterchips aufgesetzt. Nachdem das Halbleiterchip 12 sich an seinem Platz befindet, wird es dort sicher gehalten durch Anbringen von Streifen 70 aus Polyester oder Polyimid (vgl. die früher gegebenen Beispiele verwendbarer Materialien) an der obersten Schicht 16 des Anschlußteiles 10, welche Streifen sich über die obere Fläche des Halbleiterchips 12 erstrecken und es festhalten. Die Streifen 70 sind vorzugsweise etwa 0,4 mm dick, und es hat sich gezeigt, daß sie eine genügende Spannung aufweisen, um das Halbleiterchip 12 an seinem Platz zu befestigen und die Anschlußflächen 38 und 66 in wirksamem Kontakt zu halten. Die Befestigungsstreifen 70 werden an ihrem Platz mit einem geeigneten Klebemittel aus einem Akrylpolymer befestigt. Sie könnten alternativ auch an ihrem Platz durch geeignete mechanische Mittel befestigt werden wie beispielsweise eine Niete, einen Stift oder eine Klammer.

Wie in den Fig. 4 und 5 dargestellt ist, können die Oberflächen der Klemmen 26 und der Streifen 70, die das Halbleiterchip 12 berühren, für eine gesteigerte Klemmwirkung ausgebildet sein. Die gesteigerte Klemmwirkung wird erreicht durch eine Reihe von deformierbaren Vorsprüngen 72, die auf der das Halbleiterchip berührenden Fläche der Klemme 26 gebildet werden, die mit einer Kante des Halbleiterchips 12 in Eingriff kommt, wenn es auf seinen Platz 14 gedrückt wird, um Kontakt mit den Anschlußflächen 38 herzustellen. Alternativ oder als Ergänzung dazu kann die gesteigerte Klemmwirkung durch eine Reihe von festen zahnartigen Vorsprüngen 74 erzielt werden, die auf der das Halbleiterchip berührenden Fläche des Befestigungsstreifens 70 gebildet werden, der das Halbleiterchip 12 in einer gesicherten Lage hält. Es wäre ebenso möglich, wie das durch gestrichelte Linien in Fig. 5 dargestellt ist, eine Kerbe 76 in den Klemmen 26 vorzusehen, die einen entsprechenden Vorsprung 78 aufnimmt, der auf den Seiten des Halbleiterchips 12 gebildet oder daran angebracht wird. Die gleiche Wirkung läßt sich erreichen durch Umkehren der Plätze für die Kerbe 74 und den Vorsprung 78.

Im Betrieb arbeitet ein richtig eingesetztes Halbleiterchip 12 in der folgenden Weise. Die meisten Eingangs- und Ausgangssignale des Chips, die Signalpegel aufweisen, die mit der optischen Übertragung verträglich sind, werden durch das gleiche Glasfaserkabel aufgrund der doppelten früher erklärten Natur der optischen Wandler 42, die für diesen Zweck in dem Anschlußteil 10 verwendet werden, übertragen. Diese optisch gelieferten Eingangssignale für das Halbleiterchip 12 werden durch ein paar benachbarter Anschlußflächen 38 und 66 weitergeleitet und die Ausgangssignale durch einen anderen Satz benachbarter Anschlußflächen von dem Halbleiterchip 12 zu dem Glasfaserkabel 64 übertragen. Signale, die nicht über ein Glasfaserkabel übertragen werden können, wie beispielsweise die Signale für die Stromversorgung, werden dem Platz 14 in üblicher Weise durch die Teile 52 und 54 einer Schaltkarte mit gedruckten Leiterzügen zugeführt. Aufgrund der begrenzten, aber genügenden Flexibilität der Befestigungsstreifen 70 kann das Halbleiterchip sich etwas bewegen, wenn die Anschlußflächen 38 und 66 sich infolge von Wärme ausdehnen.

Die durch das Halbleiterchip 12 erzeugte Wärme wird direkt von den Anschlußflächen 38 und 66 über die wärmeleitende Substanz 44 zu den leitenden Schichten 20 und durch Konvektion zu allen leitenden Schichten 16, 18 und 20 übertragen, um für die Kühlung des Halbleiterchips zu sorgen. In dieser Weise kann das Halbleiterchip 12 mit nur geringer Rücksicht auf die negativen Wirkungen der Wärmebelastung untergebracht werden. Außerdem ist aufgrund der verwendeten optischen Kopplung keine nachteilige Wirkung auf das Betriebsverhalten vorhanden, die durch beim Schalten auftretende Störspannungen sonst entstehen würde. Daher werden durch die Erfindung viele Probleme vermieden, die sonst bei der Verbindung von monolithisch integrierten Schaltungen mit hoher Schaltkreisdichte in und mit einer Schaltkarte entstehen würden.

**Patentansprüche**

1. Anschlußteil für das lösbare Verbinden eines Halbleiterchips mit ihm, gekennzeichnet durch

a) ein mehrschichtiges Oberteil (8) mit einer leitenden oberen Schicht (16), die mit einer Öffnung (14) zur Aufnahme des Halbleiterchips versehen ist,

b) eine erste Anzahl von Löchern (28), die sich im Bereich der Öffnung der obersten Schicht vollständig durch die restlichen Schichten (18, 20) erstrecken und eine zweite Anzahl von Löchern (32), die sich zwischen den ersten Löchern befinden, sich jedoch von der Grundfläche des Oberteils aus nur durch dessen unterste Schicht (20) erstrecken,

c) eine Anzahl von Verbindungsstiften (34), die in der ersten Anzahl von Löchern (28) angebracht und an ihren Köpfen mit in die Öffnung des Oberteils hineinragenden Anschlußflächen (38) versehen sind,

d) ein mehrschichtiges Unterteil (46) mit einer oberen Isolierstoffschicht (48t) und wenigstens einer leitenden Schicht (50) darunter, die gedruckte Leiterzüge (52, 54) trägt, eine dritte Anzahl von Löchern (56) in der Isolierstoffschicht (28t) und eine vierte Anzahl von Löchern (60) in der darunter befindlichen leitenden Schicht, die koaxial zu den Löchern (56) in der Isolierstoffschicht (18t) angebracht sind,

e) eine Anzahl von Lichtleitern (64), die in den Löchern (60) der vierten Anzahl angebracht sind und sich von dort zu vorgegebenen entfernten Verbindungspunkten erstrecken,

f) eine Anzahl optischer Wandler (42), von denen jeder mit zwei Verbindungsstiften (38) und einem Lichtleiter (64) verbunden ist, um ein von dem einem Verbindungsstift erhaltenes elektrisches Signal in ein Lichtsignal umzuwandeln, das einem entfernten Verbindungspunkt zugeführt wird, oder um ein empfangenes Lichtsignal in ein elektrisches Signal für das Halbleiterchip umzuwandeln, das diesem über den anderen Verbindungsstift zugeleitet wird und

g) Befestigungsmittel (26, 70) für das Halbleiterchip (12), die im Oberteil am Rand der Öffnung angebracht sind, um das Halbleiterchip festzuhalten und seine Anschlußflächen (66) mit denen (38) der Verbindungsstifte in Kontakt zu bringen.

2. Anschlußteil nach Anspruch 1, dadurch gekennzeichnet, daß die die Öffnung (14) in der obersten Schicht (16) des Oberteiles begrenzenden Oberkanten abgeschrägt (24) sind.

3. Anschlußteil nach den Ansprüchen 1 und 2, dadurch gekennzeichnet, daß die Befestigungsmittel für das Halbleiterchip (12) eine erste Vielzahl von Kunststoffstreifen (26) vorgegebener Dicke einschließen, die an den abgeschrägten Oberkanten (24) der obersten Schicht (16) des Oberteils (18) befestigt sind.

4. Anschlußteil nach den Ansprüchen 1 bis 3, dadurch gekennzeichnet, daß die Kunststoffstreifen (26) verformbare Vorsprünge (72) auf ihrer das Halbleiterchip berührenden Fläche aufweisen, die durch den beim Einsetzen des Halbleiterchips auf sie ausgeübten Druck dieses in der Öffnung festhalten.

5. Anschlußteil nach den Ansprüchen 1 bis 4, dadurch gekennzeichnet, daß als Befestigungsmittel für das Halbleiterchip eine zweite Anzahl von Kunststoffstreifen (70) vorgegebener Dicke und Flexibilität dient, die an der leitenden oberen Schicht (16) des Oberteils (8) befestigt sind und auf der Oberfläche des Halbleiterchips (12) aufliegen und es dadurch an seinem Platz festhalten.

6. Anschlußteil nach den Ansprüchen 1 bis 5, dadurch gekennzeichnet, daß die Kunststoffstreifen (70) der zweiten Anzahl verformbarer Vorsprünge (74) an ihrer auf dem Halbleiterchip aufliegenden Fläche aufweisen.

7. Anschlußteil nach den Ansprüchen 1 bis 6, dadurch gekennzeichnet, daß die Verbindungsstifte (34) ihre Löcher (28) nur teilweise ausfüllen, so daß im unteren Teil jedes Loches (28) ein Hohlraum (36) vorhanden ist, der mit einer gut wärmeleitenden Substanz (44) völlig ausgefüllt ist.

8. Anschlußteil nach den Ansprüchen 1 bis 7, dadurch gekennzeichnet, daß die Köpfe der Verbindungsstifte (34) mit einer leitenden, nicht oxidierenden Beschichtung (38) versehen sind.

**Claims**

1. Connection part for removably connecting a semiconductor chip thereto, characterized by

a) a multi-layer top portion (8) with a conductive upper layer (16) having an opening (14) to receive the semiconductor chip,

b) a first number of holes (28) which in the area of the opening of the top layer extend completely through the remaining layers (18, 20), and a second number of holes (32) between the first holes but extending from the floor of the top portion only through the latter's bottom layer (20),

c) a number of connecting pins (34) provided in the first number of holes (28) and having at their heads connecting pads (38) protruding into the opening of the top portion,

d) a multi-layer lower portion (46) with an upper insulating layer (48t) and at least one conductive layer (50) therebeneath which carries printed circuit leads (52, 54), a third number of holes (56) in the insulating substance layer (48t), and a fourth number of holes (60) in the conductive layer therebeneath which is provided coaxially with the holes (56) in the insulating substance layer (48t),

e) a number of light transmission means (64) provided in the holes (60) of the fourth number, and extending from there to predetermined distanced connection points,

f) a number of optical transducers (42), each being connected with two connecting pins (38) and light transmission means (64) in order to convert an electrical signal received from the one connecting pin into a light signal which is applied to a distanced connecting point, or in order to convert a received light signal into an electrical signal for the semiconductor chip which is applied thereto via the other connecting pin, and

g) retention means (26, 70) for the semiconductor chip (12) which are provided in the top portion at the rim of the opening for retaining the semiconductor chip and establishing a contact between its connecting pads (66) and those (38) of the connecting pins.

2. Connection part as claimed in claim 1, characterized in that the upper edges limiting the opening (14) in the upper layer (16) of the top portion are bevelled (24).

3. Connection part as claimed in any one of claims 1 and 2, characterized in that the retention means for the semiconductor chip (12) comprise a first plurality of strips of plastic material (26) of a predetermined thickness which are affixed to the bevelled upper edges (24) of the top layer (16) of the top portion (8).

4. Connection part as claimed in any one of claims 1 to 3, characterized in that the strips of plastic material (26) comprise deformable projections (72) on their chip contacting surface which owing to the pressure exerted thereon upon the insertion of the semiconductor chip restrain the latter in the opening.

5. Connection part as claimed in any one of claims 1 to 4, characterized in that as semiconductor chip retention means a second number of strips of plastic material (70) of a predetermined thickness and flexibility is provided which are affixed to the conductive upper layer (16) of the top portion (8) and which rest on the surface of the semiconductor chip (12), thus restraining it.

6. Connection part as claimed in any one of claims 1 to 5, characterized in that the strips of plastic material (70) of the second number have deformable projections (74) on their surface resting on the semiconductor chip.

7. Connection part as claimed in any one of claims 1 to 6, characterized in that the connecting pins (34) only partially fill their holes (28) so that in the lower part of each hole (28) there is a cavity (36) completely filled with a substance (44) of high thermal conductivity.

8. Connection part as claimed in any one of claims 1 to 7, characterized in that the heads of the connecting pins (34) are coated with a conductive oxide-resistant coating (38).

**Revendications**

1. Organe de raccordement pour relier, de façon amovible, une plaquette à semiconducteurs audit organe, caractérisé par

a) un élément supérieur (8) à couches multiples, comportant une couche supérieure conductrice (16), qui est munie d'une ouverture (14) servant à loger la plaquette à semiconducteurs,

b) un premier ensemble de trous (28) qui, au voisinage de l'ouverture de la couche supérieure, traversent complètement les autres couches (18, 20), et un second ensemble de trous (32) qui sont disposés entre les premiers trous, mais qui s'étendent à partir de la surface de base de l'élément supérieur en ne traversant que la couche inférieure (20) de cet élément,

c) un ensemble de broches de liaison (34) qui sont logées dans le premier ensemble de trous (28) et sont munies, au niveau de leurs têtes, de surfaces de raccordement (38) pénétrant dans l'ouverture de l'élément supérieur,

d) un élément inférieur (46) à couches multiples, comportant une couche supérieure en matériau isolant (48t) et au moins une couche conductrice (5) sous-jacente, qui porte des voies conductrices imprimées (52, 54), un troisième ensemble de trous (56) ménagés dans la couche en matériau isolant (28t), et un quatrième ensemble de trous (60) ménagés dans la couche conductrice sous-jacente et qui sont disposés coaxialement avec les trous (56) ménagés dans la couche en matériau isolant (48t).

e) un ensemble de guides de lumière (64), qui sont disposés dans les trous (60) du quatrième ensemble et s'étendent, à partir de là, en direction de points de liaison éloignés prédéterminés,

f) un ensemble de convertisseurs optiques (42), dont chacun est relié à deux broches de liaison (34) et à un guide de lumière (64), afin de convertir un signal électrique délivré par une broche de liaison en un signal lumineux qui est envoyé vers un point de liaison éloigné, ou bien en vue de convertir un signal lumineux reçu en un signal électrique destiné à la plaquette à semiconducteurs, et qui est envoyé à cette dernière par l'intermédiaire des autres broches de liaison, et

g) des moyens de fixation (26, 70) prévus pour la plaquette à semiconducteurs (12) et qui sont disposés dans la partie supérieure du bord de l'ouverture, afin de maintenir à demeure la plaquette à semiconducteurs et d'amener en contact ses surfaces de raccordement (66) avec les surfaces de raccordement (38) des broches de liaison.

2. Organe de raccordement suivant la revendication 1, caractérisé en ce que les bords supérieurs, qui délimitent l'ouverture (14) dans la couche supérieure (16) de l'élément supérieur, sont biseautés (24).

3. Organe de raccordement selon les revendications 1 et 2, caractérisé en ce que les moyens de fixation de la plaquette à semiconducteurs (12) comprennent un premier ensemble de bandes en matière plastique (26) possédant une épaisseur prédéterminée et qui sont fixées sur les bords supérieurs biseautés (24) de la couche supérieure (16) de l'élément supérieur (18).

4. Organe de raccordement selon les revendications 1 à 3, caractérisé en ce que les bandes en matière plastique (26) comportent, sur leur surface contactant la plaquette à semiconducteurs, des parties saillantes déformables (72) qui maintiennent fixe la plaquette dans l'ouverture sous l'effet de la pression exercée lors de la mise en place de ladite plaquette à semiconducteurs sur lesdites parties saillantes.

5. Organe de raccordement selon les revendications 1 à 4, caractérisé en ce que l'on utilise comme moyens de fixation pour la plaquette à semiconducteurs, un second ensemble de bandes en matière plastique (70) possédant une épaisseur et une souplesse prédéterminées, qui sont fixées sur la couche conductrice supérieure (16) de l'élément supérieur (18) et sont en appui sur la surface supérieure de la plaquette à semiconducteurs (12), et la maintiennent de ce fait dans sa position.

6. Organe de raccordement selon les revendications 1 à 5, caractérisé en ce que les bandes en matière plastique (70) du second ensemble comporte des parties saillantes déformables (74), au niveau de leur surface qui est en appui sur la plaquette à semiconducteurs.

7. Organe de raccordement selon les revendications 1 à 6, caractérisé en ce que les broches de liaison (34) occupent seulement partiellement les trous (28), de sorte que, dans la partie inférieure de chaque trou (28), il existe une cavité (36) qui

est complètement remplie par une substance (44) conduisant bien la chaleur.

8. Organe de raccordement selon les revendications 1 à 7, caractérisé en ce que les têtes des broches de liaison (34) sont munies d'un revêtement conducteur, non oxydant (38).

8

FIG. 1

FIG. 2

FIG. 3

FIG. 4

FIG. 5